# EUROPEAN PATENT APPLICATION

(11) **EP 1 101 810 A2**
(43) Date of publication of application: **23.05.2001**
(21) Application number: 00310144.1
(22) Date of filing: 15.11.2000
(51) Int. Cl.: C09J 183/07, C09J 183/04, H01L 23/29

(54) **Silicone-based bonding sheet and semiconductor device**

(30) Priority: 15.11.1999 JP 32363299
(71) Applicant: Dow Corning Toray Silicone Co., Ltd., Tokyo (JP)
(72) Inventor: Isshiki, Minoru, Dow Corning Toray, Ichihara-shi, Chiba Prefecture (JP); Ushio, Yoshito, Dow Corning Toray, Ichihara-shi, Chiba Prefecture (JP); Yamakawa, Kimio, Dow Corning Toray, Ichihara-shi, Chiba Prefecture (JP); Nakayoshi, Kazumi, Dow Corning Toray, Ichihara-shi, Chiba Prefecture (JP)
(74) Representative: Kyle, Diana

(57) **Abstract**

A silicone-based bonding sheet comprising a sheet of a cross-linked product of a crosslinkable silicone composition, the composition containing a spherical filler having a particle size not greater than the thickness of the sheet and an average particle size of from 50% to 100% relative to the thickness of the sheet. A semiconductor device comprising a semiconductor chip, a semiconductor chip attachment site, and a silicon-based bonding sheet interposed between the chip and the attachment site.

## Description

The present invention relates to a silicone-based bonding sheet and to a semiconductor device. More particularly, the present invention relates to a silicone-based bonding sheet comprising a sheet of a cross-linked product of a crosslinkable silicone composition, the composition containing a spherical filler having a specific particle size, and to a semiconductor device comprising the bonding sheet.

Silicone-based bonding sheets consisting of a sheet of a cross-linked product of a cross-linkable silicone composition and used for bonding semiconductor chips to the corresponding attachment sites used for said chips, as well as semiconductor devices fabricated by bonding semiconductor chips to the corresponding attachment sites by means of the above-mentioned sheets, are disclosed in Japanese Laid-Open Patent Application No. Hei 11 [1999]-012546 and Japanese Laid-Open Patent Application No. Hei 11[1999]-045975.

However, the problem with this type of silicone-based bonding sheet is that when semiconductor chips are bonded to the corresponding attachment sites, wire bondability and beam lead bondability with respect to the aforementioned semiconductor chips deteriorate, and the reliability of the semiconductor devices declines. In addition, another problem with such a silicone-based bonding sheet is that because of the poor releasability of the aforementioned sheet from the release film adhered, if necessary, the aforementioned sheet is sometimes damaged when the film is peeled off at a high speed.

One object of the present invention to provide a silicone-based bonding sheet offering excellent wire bondability and beam lead bondability upon adhesion of a semiconductor chip to a chip attachment site, excellent releasability from a release film adhered to at least one side of the silicone-based bonding sheet. Another object of the invention is to provide a semiconductor device of superior reliability.

The present invention is directed to a silicone-based bonding sheet comprising a sheet of a cross-linked product of a crosslinkable silicone composition, the composition containing a spherical filler having a particle size not greater than the thickness of the sheet and an average particle size of from 50% to 100% relative to the thickness of the sheet.

The present invention is also directed to a semiconductor device comprising a semiconductor chip, a semiconductor chip attachment site, and a silicone-based bonding sheet interposed between the chip and the attachment site.

FIG. 1 shows a cross-sectional view of a semiconductor of a first embodiment of the present invention.

FIG. 2 shows a cross-sectional view of a semiconductor device of a second embodiment of the present invention.

FIG. 3 shows a cross-sectional view of a semiconductor device of a third embodiment of the present invention.

The silicone-based bonding sheet of the present invention is used for bonding semiconductor chips to the corresponding attachment sites and is made up of a cross-linked product of a cross-linkable silicone composition. The cross-linked product is preferably elastomeric, such as a rubber, gel, etc. Examples of the cross-linkable silicone composition include hydrosilation reaction cross-linkable silicone compositions, condensation reaction cross-linkable silicone compositions, and organic peroxide cross-linkable silicone compositions. Preferably, the cross-linkable silicone composition is a hydrosilation reaction cross-linkable silicone composition. More preferably, the cross-linkable silicone composition is a hydrosilation reaction cross-linkable silicone composition comprising:
(A) an organopolysiloxane having at least two silicon-bonded alkenyl groups per molecule,
(B) an organopolysiloxane having at least two silicon-bonded hydrogen atoms per molecule,
(C) an adhesion promoter,
(D) a hydrosilation reaction catalyst, and
(E) a spherical filler having a particle size not greater than the thickness of the resultant silicone-based bonding sheet and an average particle size of from 50% to 100% relative to the aforementioned thickness.

Component (A) of the above-described composition is an organopolysiloxane having at least two silicon-bonded alkenyl groups per molecule. Component (A) is the main component of the composition. The molecular structure of component (A) can be linear, partially branched linear, branched, or network. In addition, the silicon-bonded alkenyl groups of component (A) are exemplified by groups such as vinyl, allyl, butenyl, pentenyl, and hexenyl, with vinyl being particularly preferable. The alkenyl groups can be located at terminal, pendant, or pendant and terminal positions of the organopolysiloxane. In addition, the silicon-bonded groups other than alkenyl groups in component (A) are exemplified by alkyl, such as methyl, ethyl, propyl, butyl, pentyl, hexyl, and heptyl; aryl, such as phenyl, tolyl, xylyl, and naphthyl; aralkyl, such as benzyl and phenethyl; halogenated alkyl, such as chloromethyl, 3-chloropropyl, and 3,3,3-trifluoropropyl, and other substituted and unsubstituted univalent hydrocarbon groups, with methyl and phenyl being particularly preferable. Additionally, in order for the produced silicone-based bonding sheets to possess superior cold resistance and further enhance the reliability of semiconductor devices fabricated using such silicone-based bonding sheets, the content of phenyl groups relative to the silicon-bonded organic groups in component (A) is, preferably, not less than 1 mol%, and, even more preferably, in the range of from 1 mol% to 60 mol%, and especially preferably, in the range of from 1 mol% to 30 mol%.

Although, there are no limitations concerning the viscosity of component (A), preferably it has a viscosity at 25 °C of from 100 mPa·s to 1,000,000 mPa·s. Also, preferably, component (A) contains not more than 500 ppm by weight of low molecular weight siloxane having a vapor pressure at 200 °C of at least 10 mmHg. This is due to the fact that if the content of the low molecular weight siloxane exceeds the above-mentioned range, this may lead to wire bondability deterioration in the fabrication of semiconductor devices by means of the resultant silicone-based bonding sheets.

Component (B) of the above-described silicone composition is an organopolysiloxane having at least two silicon-bonded hydrogen atoms per molecule. The organopolysiloxane of component (B) serves as a crosslinking agent for the above-described composition. The molecular structure of component (B) can be linear, partially branched linear, branched, cyclic, or network. In addition, the silicon-bonded hydrogen atoms can be located at terminal, pendant, or both terminal and pendant positions in the organopolysiloxane. Additionally, silicon-bonded groups other than hydrogen atoms in component (B) are exemplified by alkyl, such as methyl, ethyl, propyl, butyl, pentyl, hexyl, and heptyl; aryl, such as phenyl, tolyl, xylyl, and naphthyl; aralkyl, such as benzyl and phenethyl; halogenated alkyl groups, such as chloromethyl, 3-chloropropyl, and 3,3,3-trifluoropropyl, and other substituted and unsubstituted univalent hydrocarbon groups, with methyl and phenyl being particularly preferable. In addition, although there are no limitations concerning the viscosity of component (B), preferably it has a viscosity at 25°C of from 1 mPa·s to 100,000 mPa·s.

The concentration of component (B) is sufficient for crosslinking the above-described composition. Specifically, preferably, it is such that the amount of silicon-bonded hydrogen atoms in the component per 1 mol of silicon-bonded alkenyl groups in component (A) is in the range of from 0.5 mol to 10 mol, and, especially preferably, in the range of from 1 mol to 3 mol. This is due to the fact that when the content of component (B) is lower than the lower limit of the above-mentioned range, the resultant cross-linkable silicone composition has does not always undergo complete cross-linking, and, on the other hand, when it exceeds the upper limit of the above-mentioned range, the heat resistance of the resultant cross-linked silicone products tends to deteriorate.

Component (C) of the above-described silicone composition is an adhesion promoter for imparting superior adhesive properties to the cross-linked product of the composition. The adhesion promoter of component (C) is exemplified by silatrane derivatives or mixtures of organosiloxanes having at least one silicon-bonded alkenyl group and at least one silicon-bonded hydroxy group in one molecule and siloxanes or silanes having at least one silicon-bonded alkoxy group and/or siloxanes having at least one silicon-bonded alkoxy group and at least one silicon-bonded hydrogen atom or silicon-bonded alkenyl group in one molecule.

The concentration of component (C) is sufficient for imparting excellent adhesive properties to the cross-linked product of the above-described composition. The concentration of component (C) is typically from 0.01 parts by weight to 20 parts by weight, and, especially preferably, in the range of from 0.1 parts by weight to 10 parts by weight, per 100 parts by weight of component (A). When the concentration of component (C) is lower than the lower limit of the above-mentioned range, the adhesive properties of the resultant cross-linked product tend to decline. On the other hand, if the concentration of component (C) exceeds the upper limit of the above-mentioned range, this does not affect the adhesive properties of the resultant cross-linked product, but the mechanical strength of the cross-linked product tends to be affected.

Component (D) of the above-described silicone composition is a hydrosilation reaction catalyst that promotes the crosslinking reaction of the composition. It is exemplified by platinum catalysts, rhodium catalysts, palladium catalysts, and other well-known hydrosilation reaction catalysts. Platinum micropowder, platinum black, platinum supported on silica micropowder, platinum supported on activated charcoal, chloroplatinic acid, alcohol solutions of chloroplatinic acid, olefin complexes of platinum, alkenylsiloxane complexes of platinum, and other platinum-based catalysts are especially preferable in view of the excellent reaction rates achieved.

The concentration of component (D) is sufficient for promoting the crosslinking reaction of the above-described composition. When using a platinum-based catalyst, the platinum metal content in the silicone composition is preferably in the range of from 0.01 ppm to 1,000 ppm by wieght, or, especially preferably, in the range of from 0.1 ppm to 500 ppm by wieght. When the concentration of component (D) is lower than the lower limit of the above-mentioned range, the rate of crosslinking tends to considerably decrease. On the other hand, when the concentration of component (D) exceeds the upper limit of the above-mentioned range, the rate of crosslinking is unaffected, but other problems may occur, such as discoloration of the cross-linked product, etc.

Component (E) is a spherical filler having a particle size not greater than the thickness of the silicone-based bonding sheet and an average particle size of at least 50%, preferably from 50 to 100% relative to the thickness of the sheet. For example, the average particle size of the spherical filler is 50 to 98 %, relative to the thickness of the sheet. In particular embodiments of the invention the average particle size of the spherical filler is 50 to 95 %, preferably 75 % to 95 % of the thickness of the sheet. The spherical filler improves wire bondability and beam lead bondability upon bonding semiconductor chips to the corresponding attachment sites. Furthermore, it allows for excellent peeling of the release film adhered, if necessary, to at least one side of the silicone-based bonding sheet, thereby preventing damage to the aforementioned sheet. The spherical filler can be organic or inorganic; preferably, however, it is inorganic. Spherical inorganic fillers are exemplified by silica particles, alumina particles, titanium oxide particles, and glass beads. In addition, spherical organic fillers are exemplified by polystyrene resin particles, acrylic resin particles, polycarbonate resin particles, and nylon resin particles. The spherical filler has an average particle size typically from 1µm to 1,000 µm, preferably from 1µm to 500 µm, more preferably from 10 µm to 200 µm, and most preferably from 10 µm to 100 µm. In addition, the particles have a length-to-width aspect ratio preferably from 1.0∼1.5 and, more preferably from 1.0∼1.1. Furthermore, in order to increase the reliability of semiconductor devices fabricated using the resultant silicone-based bonding sheet, preferably the total content of uranium and thorium in component (E) does not exceed 1 ppb.

The concentration of component (E) is preferably from 0.1 parts by weight to 100 parts by weight per 100 parts by weight of component (A). When the concentration of component (E) is lower than the lower limit of the above-mentioned range, the wire bondability and beam lead bondability of semiconductor devices fabricated using the obtained silicone-based bonding sheet deteriorate, and, furthermore, the releasability of the resultant silicone-based bonding sheet from the release film tends to remain unchanged. On the other hand, when the concentration of component (E) exceeds the upper limit of the above-mentioned range, the reliability of the semiconductor devices fabricated using the resultant silicone-based bonding sheet tends to deteriorate.

In addition, in order to adjust the rate of the crosslinking reaction and produce a uniform cross-linked sheet, the above-described cross-linkable silicone composition preferably contains 3-methyl-1-butyne-3-ol, 3,5-dimethyl-1-hexyne-3-ol, phenyl butynol, and other alkyne alcohols; 3-methyl-3-pentene-1-yne, 3,5-dimethyl-3-hexene-1-yne, and other ene-yne compounds; 1,3,5,7-tetramethyl-1,3,5,7-tetravinylcyclotetrasiloxane, 1,3,5,7-tetramethyl-1,3,5,7-tetrahexenylcyclotetrasiloxane, benzotriazole, and other reaction inhibitors. There are no limitations concerning the content of the reaction inhibitors, but it is preferable, however, that it should be in the range of from 0.00001 parts by weight to 5 parts by weight per 100 parts by weight of component (A).

In addition to components (A) through (E) above, the cross-linkable silicone composition can further comprise inorganic fillers having a particle size considerably smaller than that of component (E), for example, precipitated silica, wet process silica, fumed silica, calcined silica, titanium oxide, alumina, glass, quartz, alumosilicic acid, iron oxide, zinc oxide, calcium carbonate, carbon black, silicon carbide, silicon nitride, boron nitride, fillers obtained by treating the above-mentioned fillers with organohalosilane, organoalkoxysilane, organosilazane, and other organosilicon compounds, and, furthermore, micropowders of silicone resin, epoxy resin, fluororesin, and other organic resins, powders of silver, copper, and other electrically conductive metals, and other fillers, dyes, pigments, and flame retardants.

In order to protect the adhesive surface of the silicone-based bonding sheet of the present invention from contamination in storage and during handling, a release film is preferably adhered to at least one side thereof. The release film is peeled off when the sheet is used. Polyimide resin, polyether imide resin, polysulfone resin, polyether sulfone resin, polyester resin, polyether resin, epoxy resin, phenolic resin, polyamide resin, and other organic resins are suggested as the raw materials used for the fabrication of the release film. The release film is exemplified by the above-mentioned organic resin films, and, furthermore, by films produced by coating the surface of the above-mentioned organic resin films with fluororesin and other organic resins.

The methods suitable for preparing the silicone-based bonding sheet include a method wherein the above-mentioned cross-linkable silicone composition containing a spherical filler is sandwiched between release films, shaped into a sheet-like form, and cross-linked; and a method wherein a uniform coating layer of the cross-linkable silicone composition is formed on the surface of a release film and subjected to crosslinking, so that the release film is adhered to the surface of the resultant cross-linked material. Preferably the silicone-based bonding sheet is fabricated using release films possessing good releasability from the cross-linked product of the cross-linkable silicone composition and having a dielectric constant greater than the dielectric constant of said cross-linked product. Such release films are exemplified by the films mentioned above. The above-described release films can also be used as films for protecting the adhesive surface of the silicone-based bonding sheet. However, other release films can be used for this purpose. In such a case, there are no limitations concerning the dielectric constant of the release films. Such release films are exemplified by the films mentioned above.

The cross-linkable silicone composition can be cross-linked at a temperature from room temperature to 200 °C and preferably from room temperature to 120 °C.

The semiconductor device of the present invention is fabricated by partially or entirely bonding one of the sides of semiconductor chips, such as semiconductor chips used in in hybrid ICs, memory elements, such as monolithic ICs, thyristors, transistors, and diodes, to semiconductor chip attachment sites by means of the above-mentioned silicone-based bonding sheet. Also, examples of the semiconductor device of the present invention include diodes, transistors, thyristors, monolithic ICs, hybrid ICs, LSI and VLSI devices.

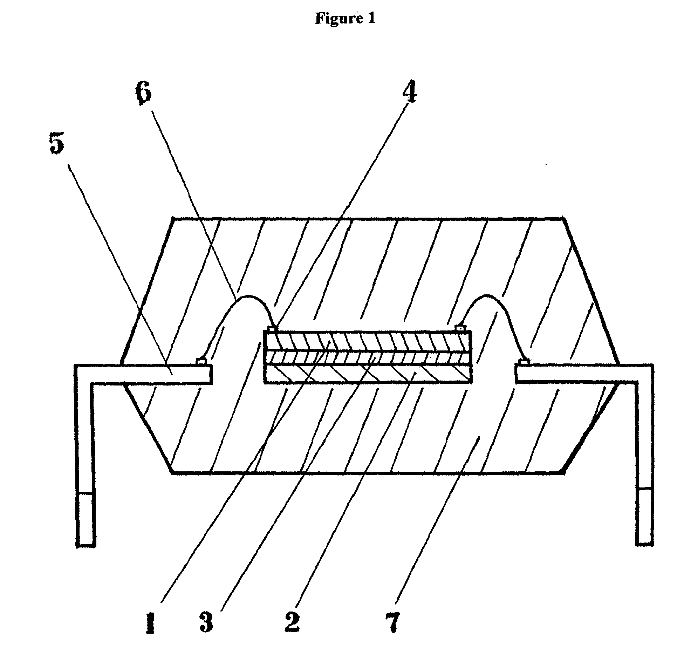

One embodiment of the semiconductor device of the present invention, which is shown in Figure 1, is fabricated by bonding a semiconductor chip (1) to a semiconductor chip attachment site (2) by means of the above-described silicone-based bonding sheet (3). In the semiconductor device of the present invention, the semiconductor chip (1) is produced by forming an electronic circuit on a surface made up of silicon, galliumarsenic, and the like. Also, the semiconductor chip attachment site (2) is made up of copper, iron-based alloy, or another metal and is commonly called a tab.

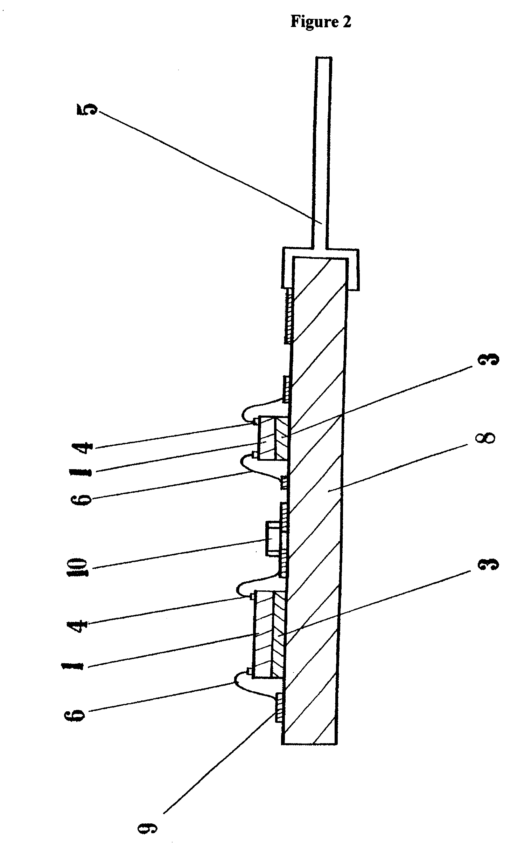

A second embodiment of the semiconductor device of the present invention, which is shown in FIG. 2, is fabricated by bonding a semiconductor chip (1) to a circuit substrate (8) by means of the above-described silicone-based bonding sheet (3), with the circuit substrate (8) used as a semiconductor chip attachment site. In the semiconductor device of the present invention, the circuit substrate (8) is made up of ceramic, glass, or another base material, with circuit wiring (9) made up of metal, such as gold, silver, or copper, formed on its surface. In addition, capacitors, resistors, coils, and other electric elements (10) may be mounted on the surface of the circuit substrate (8).

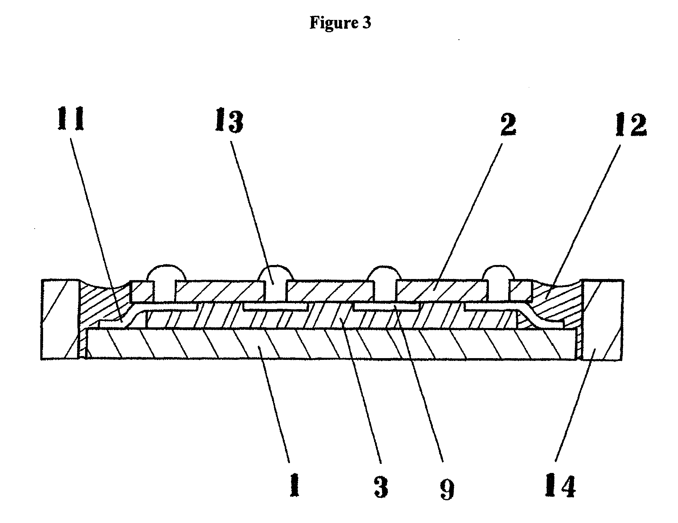

A third embodiment of the semiconductor device of the present invention is shown in FIG. 3. The semiconductor chip (1) is bonded by means of the silicone-based bonding sheet (3) in such a manner that it faces the semiconductor chip attachment site (2). In addition, circuit wiring (9) is formed on the surface of the semiconductor chip attachment site (2) facing the semiconductor chip (1), with the circuit wiring (9) electrically interconnected with the semiconductor chip (1) with the help of beam leads (11). Also, the beam leads (11) are partially or entirely sealed or encapsulated by means of a sealing or encapsulating agent (12), such as silicone resin and the like. Solder balls (13) are provided in the semiconductor chip attachment site (2) in order to mount it to the substrate, and, furthermore, a frame (14) is provided in order to protect the semiconductor chip (1) from external mechanical stress. In the semiconductor device of the present invention, the frame (14) may be designed in an arbitrary fashion.

The semiconductor device of the present invention can be fabricated by joining a semiconductor chip (1) to a semiconductor chip attachment site or circuit substrate (8) with the above-described silicone-based bonding sheet; bonding the semiconductor chip (1) to the semiconductor chip attachment site or circuit substrate (8) by allowing the device to stand at room temperature or by heating it; wiring bonding pads (4) in the upper section of the semiconductor chip (1) to a lead frame (5); or circuit wiring (9) with bonding wires (6) made of metal, such as gold, copper, aluminum, etc.; or interconnecting the beam leads (11) of the semiconductor chip attachment site (2) with the semiconductor chip (1) by means of beam lead bonding. In addition, ultrasonic bonding, thermal bonding, ultrasonic thermal bonding, and similar methods are commonly used for wire bonding or beam lead bonding. A method, in which the above-mentioned silicone-based bonding sheet (3) is adhered to a semiconductor chip attachment site (2) or a circuit substrate (8) and then a semiconductor chip (1) is adhered to the silicone-based bonding sheet (3) and heated, and a method, in which the above-mentioned silicone-based bonding sheet is adhered to a semiconductor chip (1) and then the semiconductor chip (1) is adhered to a semiconductor chip attachment site (2) or a circuit substrate (8) by means of the silicone-based bonding sheet (3), are suggested as examples of the methods used for bonding a semiconductor chip (1) to a semiconductor chip attachment site (2) or a circuit substrate (8) by means of the above-described silicone-based bonding sheet (3). In addition, although there are no particular limitations concerning the temperature, at which the above-mentioned silicone-based bonding sheet (3) should be bonded, a temperature in the range of from 50°C to 200°C is preferable, and a temperature of from 100°C to 150°C is even more preferable. Furthermore, in the semiconductor device of the present invention, it is desirable that after wire bonding on the semiconductor chip (1), the surface of the semiconductor chip (1) should be treated with a gel-like or rubber-like silicone-based coating agent or encapsulating agent. Furthermore, it is preferable that such a semiconductor chip (1) should be resin sealed with a sealing resin (7), such as silicone resin or epoxy resin.

The silicone-based bonding sheet of the present invention is characterized by excellent wire bondability and beam lead bondability upon bonding semiconductor chips to the corresponding attachment sites, and, furthermore, by excellent releasability from the release film adhered, if necessary, on at least one side of the silicone-based bonding sheet. In addition, because the semiconductor chips are bonded to the semiconductor chip attachment sites by means of the silicone-based bonding sheet, the semiconductor device of the present invention is characterized by excellent wire bondability, beam lead bondability, and superior reliability.

### EXAMPLES

Explanations regarding the silicone-based bonding sheet and the semiconductor device of the present invention will be now given by referring to examples. In addition, the values of viscosity in the examples were measured at 25 °C. The measurement of the low molecular weight siloxane content and the evaluation of the characteristics of the silicone-based bonding sheet and those of the semiconductor device in the examples were carried out in accordance with the methods described hereinbelow.

### Measurement of Low Molecular Weight Siloxane Content

After extracting low molecular weight siloxane contained in the organopolysiloxane serving as the main component with the help of acetone, the acetone-extracted low molecular weight siloxane was subjected to quantitative analysis using gas chromatography (GC-9A, from Shimadzu Corporation, FID-type). The content of low molecular weight siloxane having a vapor pressure at 200 °C of not less than 10 mmHg in the organopolysiloxane serving as the main component was obtained from the amount of the low molecular weight siloxane.

### Hardness of Silicone-based Bonding Sheet

Prior to bonding sheet molding, the cross-linkable silicone composition was poured into a mold with a thickness of 6 mm and subjected to pressure for 10 minutes at 120 °C, whereupon the durometer hardness of the resultant test piece was measured using a Type A durometer specified in JIS K 6253.

### Peel Strength of Silicone-based Bonding Sheet

A three-layer silicone-based bonding sheet was cut into 1 cm x 15 cm strips, whereupon a Tensilon testing machine was used to peel off the covering film from one side thereof at a 180° angle and a speed of 100 mm/min while taking readings of the average value of stress, whose value was used as the peel strength.

### Method of Fabricating Semiconductor Device and Evaluating Wire Bonding

After joining a semiconductor chip (3 cm × 3 cm) and a semiconductor chip attachment site (3 cm × 3 cm) with a silicone-based bonding sheet (1 cm × 1 cm), a force of 10 kgf/cm² was applied thereto to cause them to adhere to each other while heating them at 200 °C for 1 minute. After that, a lead frame was connected with wires to bonding pads provided in the upper portion of the semiconductor chip by the ultrasonic thermal bonding method (temperature: 160 °C ∼ 250 °C, load 30∼100 mg/wire). Subsequently, the neck shape of the wires and bonding pads, or wires and lead frame, was examined under a microscope. At such time, wire bond quality was examined by applying tension to the wires, and the proportion of the wires with defective attachment in the total number of the wires (number of fabricated semiconductor device specimens, i.e. 30 × number of lead frames per 1 semiconductor device, i.e. 30 x 12 = 360) was used as an evaluation of wire bondability.

### Method of Evaluating Semiconductor Device Failure Rate

The fabricated semiconductor device specimens were plugged into a socket and tested by passing an electric current between the terminals of the lead frame (5). The proportion of the semiconductor devices in which current passage failures occurred during the test was used as an evaluation of the semiconductor device failure rate.

### Example 1

To prepare component (A), 83 parts by weight of dimethylpolysiloxane blocked by dimethylvinylsiloxy groups at both terminal ends of the molecular chain (content of silicon-bonded vinyl groups = 0.08 wt%) with a viscosity of 40,000 mPa·s, in which the content of low molecular weight siloxane with a vapor pressure at 200°C of not less than 10 mmHg was 0.01 wt%, 17 parts by weight of copolymer of methylvinylsiloxane and dimethylsiloxane blocked by dimethylvinylsiloxy groups at both terminal ends of the molecular chain (content of silicon-bonded vinyl groups = 0.84 wt%) with a viscosity of 6,000 mPa·s, in which the content of low molecular weight siloxane with a vapor pressure at 200°C of not less than 10 mmHg was 0.01 wt%, 1.5 parts by weight water, 3 parts by weight hexamethyldisilazane, and 10 parts by weight dry process silica micropowder with a specific surface area of 200 m²/g were placed in a Ross mixer and mixed for 1 hour. Subsequently, upon reducing the pressure inside the Ross mixer and raising the temperature to 170 °C, mixing was continued for another 2 hours. After that, the Ross mixer was cooled with cooling water, obtaining a semi-transparent paste-like base. Next, 3.5 parts by weight of a copolymer of methylhydrogensiloxane and dimethylsiloxane blocked by trimethylsiloxy groups at both terminal ends of the molecular chain (content of silicon-bonded hydrogen atoms = 0.7 wt%) with a viscosity of 5 mPa·s as component (B), 1.0 part by weight of organopolysiloxane represented by the average unit formula: 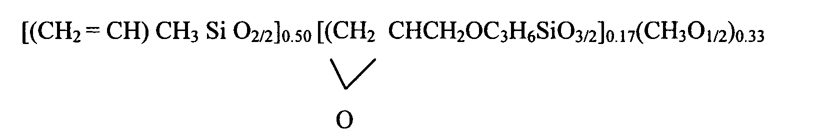 as component (C), 1,3-divinyl-1,1,3,3-tetramethyldisiloxane complex of platinum (in an amount such that, by weight, the content of platinum metal in the present composition due to the complex was 5 ppm) as component (D), 4 parts by weight of spherical silica micropowder with an average particle size of 40 µm, a length-to-width aspect ratio of 1.05, a standard deviation of particle size distribution of 3 µm, and a total content, by weight, of uranium and thorium of not more than 0.1 ppb as component (E), and 0.01 parts by weight of 3-phenyl-1-butyne-3-ol as an addition reaction inhibitor were uniformly mixed with 100 parts by weight of the obtained base, preparing a hydrosilation reaction cross-linkable silicone composition with a viscosity of 70,000 mPa-s.

Next, a flat 3-layer silicone-based bonding sheet consisting of a cross-linked product of said composition was fabricated by sandwiching the obtained cross-linkable silicone composition between sheets of polyether sulfone resin film with a dielectric constant of 3.5 and a thickness of 50 µm and adjusting the thickness of the above-mentioned cross-linkable silicone composition to 50 µm using a stainless steel two-roll mill with properly adjusted clearance, and then carrying out heating for 30 minutes at 80 °C in a hot air circulating oven.

After measuring the peel strength of the 3-layer silicone-based bonding sheet, semiconductor devices were fabricated using the silicone-based bonding sheet with its release film peeled off, followed by measuring the wire bondability and semiconductor device failure rate. The results are shown in Table 1.

### Example 2

A cross-linkable silicone composition was prepared in the same manner as in Application Example 1, with the exception of adding 2 parts by weight of a spherical silica powder with an average particle size of 30 µm, a length-to-width aspect ratio of 1.05, a standard deviation of particle size distribution of 3 µm, and a total content, by weight, of uranium and thorium of not more than 0.1 ppb as component (E). Subsequently, a flat 3-layer silicone-based bonding sheet was made in the same manner as in Application Example 1, except that the thickness of the cross-linkable silicone composition was 35 µm. The results for the peel strength of the 3-layer silicone-based bonding sheet, wire bondability and semiconductor device failure rate are shown in Table 1.

### Comparative Example 1

A cross-linkable silicone composition was prepared in the same manner as in Application Example 1, except that component (E) was not added. Subsequently, a flat 3-layer silicone-based bonding sheet (3) was made in the same manner as in Application Example 1. The results for the peel strength of the 3-layer silicone-based bonding sheet, wire bondability and semiconductor device failure rate are shown in Table 1.

### Comparative Example 2

A 3-layer silicone-based bonding sheet was made in the same manner as in Application Example 1, except that the thickness of the cross-linkable silicone composition was 100 µm. The results for the peel strength of the 3-layer silicone-based bonding sheet, wire bondability and semiconductor device failure rate are shown in Table 1.

**Table 1**

| | Example 1 | Example 2 | Example 1 | Example 2 |
|---|---|---|---|---|
| Sheet thickness (µm) | 50 | 35 | 50 | 100 |
| Sheet hardness | 35 | 35 | 33 | 35 |
| Peel strength (N/m) | 0.6 | 0.6 | 0.9 | 0.9 |
| Wire bondability | 0/360 | 0/360 | 360/360 | 360/360 |
| Semiconductor device failure rate | 0/30 | 0/30 | 30/30 | 30/30 |

## Claims

1. A silicone-based bonding sheet comprising a sheet of a cross-linked product of a crosslinkable silicone composition, the composition containing a spherical filler having a particle size not greater than the thickness of the sheet and an average particle size of at least 50% relative to the thickness of the sheet.

2. The bonding sheet according to claim 1, wherein the cross-linkable silicone composition is a hydrosilation reaction cross-linkable silicone composition.

3. The bonding sheet according to claim 2, wherein the hydrosilation reaction crosslinkable silicone composition comprises:
(A) an organopolysiloxane having at least two silicon-bonded alkenyl groups per molecule,
(B) an organopolysiloxane having at least two silicon-bonded hydrogen atoms per molecule,
(C) an adhesion promoter,
(D) a hydrosilation reaction catalyst, and
(E) a spherical filler having a particle size not greater than the thickness of the sheet and an average particle size of at least 50%, preferably from 50% to 100% relative to the thickness of the sheet.

4. The bonding sheet according to any of claims 1 to 3, wherein component (A) contains silicon-bonded organic groups free of aliphatic unsaturation.

5. The bonding sheet according to claim 4, wherein the silicon-bonded organic groups free of aliphatic unsaturation are independently selected from methyl and phenyl.

6. The bonding sheet according to claim 4, wherein 1 mol% to 60 mol% of the silicon-bonded organic groups in component (A) are phenyl.

7. The bonding sheet according to any of claims 3 to 6, wherein component (A) contains not greater than 500 ppm by weight of low molecular weight siloxane having a vapor pressure at 200 °C of at least 10 mmHg.

8. The bonding sheet according to any of claims 3 to 7, wherein the concentration of component (B) is sufficient to provide from 0.5 to 10 silicon-bonded hydrogen atoms per silicon-bonded alkenyl group in component (A).

9. The bonding sheet according to any of claims 3 to 8, wherein the concentration of component (C) is from 0.1 to 10 parts by weight per 100 parts by weight of component (A).

10. The bonding sheet according to any of claims 3 to 9, wherein component (D) is a platinum-based catalyst.

11. The bonding sheet according to any of claims 3 to 10, wherein component (E) is an inorganic spherical filler selected from silica particles, alumina particles, titanium oxide particles, and glass beads.

12. The bonding sheet according to any of claims 3 to 10, wherein component (E) is an organic spherical filler selected from polystyrene resin particles, acrylic resin particles, polycarbonate resin particles, and nylon resin particles.

13. The bonding sheet according to any of claims 3 to 12, wherein component (E) has an average particle size of from 1 to 500 µm.

14. The bonding sheet according to any of claims 3 to 13, wherein component (E) contains not greater than 1 ppb of uranium and thorium.

15. The bonding sheet according to any of claims 3 to 14, wherein the concentration of component (E) is from 0.1 to 100 parts by weight per 100 parts by weight of component (A).

16. A semiconductor device comprising a semiconductor chip, a semiconductor chip attachment site, and the bonding sheet according to any of claims 1 to 15, interposed between the chip and the attachment site.

17. The semiconductor device according to claim 16, wherein the semiconductor chip attachment site is a tab.

18. The semiconductor device according to claim 16, wherein the semiconductor chip attachment site is a circuit substrate.
